# EUROPEAN PATENT APPLICATION

(11) **EP 4 382 219 A1**
(43) Date of publication of application: **12.06.2024**
(21) Application number: 22851013.7
(22) Date of filing: 14.07.2022
(51) Int. Cl.: B08B 3/04, B08B 13/00, C01B 33/02

(54) **CLEANING BASKET**

(30) Priority: 06.08.2021 JP 2021130347
(71) Applicant: Tokuyama Corporation, Shunan-shi, Yamaguchi 745-8648 (JP)
(72) Inventor: ICHITSUBO, Koki, Shunan-shi, Yamaguchi 745-8648 (JP)
(74) Representative: Bittner, Thomas L.
(86) International application number: PCT/JP2022/027648
(87) International publication number: WO 2023/013379

(57) **Abstract**

In order to prevent contamination of polycrystalline silicon in a cleaning step, a cleaning basket (1) is a cleaning basket (1) used for cleaning polycrystalline silicon in a state in which the polycrystalline silicon is accommodated in the cleaning basket and includes a plurality of component parts (10) each made of a resin, the plurality of component parts (10) being coupled to each other by screwing screws (N) each made of a resin. (Fig. 1)

## Description

The present invention relates to a cleaning basket used when polycrystalline silicon is cleaned.

### Background

Polycrystalline silicon used as, for example, a raw material for silicon semiconductors or a raw material for solar cells needs to be highly pure, and a production process of the polycrystalline silicon includes a cleaning step of removing contaminants and the like adhered to the polycrystalline silicon. In the cleaning step, cleaning by etching and cleaning with pure water are performed in a state in which the polycrystalline silicon is accommodated in a dedicated cleaning basket. Patent Literature 1 discloses, as such a cleaning basket that is used when polycrystalline silicon is cleaned, for example, a cleaning basket which is formed with use of resin boards so as to have a box shape and which is for accommodating the polycrystalline silicon.

Further, Patent Literature 2 indicates that in a case where the cleaning by etching is performed in a state in which polycrystalline silicon is accommodated in a cleaning basket made of a resin, a surface of the polycrystalline silicon which has been cleaned is contaminated by organic components and carbon that are derived from the cleaning basket. Furthermore, paragraphs [0039] to [0041] of Patent Literature 2 disclose that such contamination due to the resin of the cleaning basket occurs more severely when the resin is degraded as a result of repeating the cleaning by etching than when the cleaning basket is new.

### Citation List

[Patent Literature 1]
   Japanese Patent Application Publication Tokukai No. 2011-68554
[Patent Literature 2]
   Japanese Patent Application Publication Tokukai No. 2020-128332

### Summary

### Technical Problem

The present inventors has found that, in the cleaning basket disclosed in Patent Literature 1, in a case where parts of the cleaning basket which are to be immersed in fluonitric acid serving as a cleaning liquid in the cleaning step are welded together, the parts welded are more easily degraded than the other resin parts, and this contributes to the above-described contamination due to the cleaning basket. In particular, there is a problem that repetition of the etching cleaning causes cracking and pealing due to acid, resulting in occurrence of resin fragments. Since the resin fragments are not dissolved in the cleaning liquid, the resin fragments adhere to the polycrystalline silicon. This remarkably aggravate contamination of the polycrystalline silicon.

It is an object of an aspect of the present invention to prevent contamination of polycrystalline silicon in a cleaning step.

### Solution to Problem

In order to solve the foregoing problem, a cleaning basket in accordance with an aspect of the present invention is a cleaning basket used for cleaning polycrystalline silicon in a state in which the polycrystalline silicon is accommodated in the cleaning basket, the cleaning basket including a plurality of component parts each made of a resin, the plurality of component parts being coupled to each other by screwing screws each made of a resin.

### Advantageous Effects of Invention

According to an aspect of the present invention, it is possible to prevent contamination of polycrystalline silicon in a cleaning step.

### Brief Description of Drawings

- Fig. 1: is a side view illustrating a cleaning basket in accordance with an embodiment of the present invention.
- Fig. 2: is a plan view illustrating the cleaning basket.
- Fig. 3: is a front view illustrating the cleaning basket.
- Fig. 4: is a cross-sectional view taken along line A-A in Fig. 1.
- Fig. 5: is a plan view illustrating a bottom plate of the cleaning basket.
- Fig. 6: is a plan view illustrating a first side plate of the cleaning basket.
- Fig. 7: is a plan view illustrating a second side plate of the cleaning basket.
- Fig. 8: is a plan view illustrating a third side plate of the cleaning basket.
- Fig. 9: is a view for describing locking.

### Description of Embodiments

The following will describe an embodiment of the present invention in detail.

### <Method for Producing Polycrystalline Silicon>

A method for producing polycrystalline silicon to be cleaned includes, for example, a silicon depositing step of depositing polycrystalline silicon by reacting a chlorosilane compound and hydrogen in a reactor. The Siemens process is known as a method for depositing polycrystalline silicon. In the Siemens process, trichlorosilane and hydrogen are reacted in a bell-shaped (bell-jar) reactor. Then, polycrystalline silicon is deposited on the surface of a core rod which is for polycrystalline silicon deposition and which is provided so as to set up inside the reactor, so that a grown polycrystalline silicon rod is obtained.

The method for producing the polycrystalline silicon may further include the step of crushing the polycrystalline silicon rod obtained in the silicon depositing step and the step of classifying the polycrystalline silicon thus crushed. Furthermore, the method for producing the polycrystalline silicon includes a cleaning step of cleaning the polycrystalline silicon crushed or the polycrystalline silicon classified and a drying step of drying the polycrystalline silicon cleaned. This can provide highly pure polycrystalline silicon. The polycrystalline silicon is used for semiconductor components and thus needs to be highly pure.

### <Method for Cleaning Polycrystalline Silicon>

In the cleaning step, fluonitric acid as a cleaning liquid is brought into contact with the polycrystalline silicon. The "fluonitric acid" refers to an aqueous solution in which nitric acid and hydrogen fluoride are mixed. On the polycrystalline silicon taken out of the reactor, usually, an oxide layer containing a contaminant may be formed, due to natural oxidation, so as to have a thickness of several nanometers. The oxide layer is a layer made of SiO₂. Bringing this polycrystalline silicon into contact with the fluonitric acid causes a reaction as follows.

Mainly due to the action of the hydrogen fluoride, the surface of the polycrystalline silicon is etched and the oxide layer present on the surface is removed. Meanwhile, mainly due to the action of the nitric acid, a new oxide layer is formed on the surface of the polycrystalline silicon. Simultaneous progression of (i) removal of the oxide layer and (ii) formation of the new oxide layer causes the polycrystalline silicon to be etched, so that the contaminant adhered to the surface of the polycrystalline silicon and the contaminant incorporated in the polycrystalline silicon is removed. Such a contaminant includes, for example, organic substances, metal, and resin. Major examples of the metal that can be contaminants or impurities encompass Na, Mg, Al, K, Ca, Cr, Fe, Ni, Co, Cu, Zn, and W.

Specific examples of a method for bringing the fluonitric acid into contact with the polycrystalline silicon encompass a method in which a cleaning basket 1 accommodating the polycrystalline silicon is immersed into a first cleaning bath filled with the fluonitric acid. The cleaning basket 1 will be described later. After the cleaning basket 1 has been immersed in the first cleaning bath, the cleaning basket 1 is taken out of the first cleaning bath and is then immersed into a second cleaning bath filled with ultrapure water. This can wash away the fluonitric acid adhered to the polycrystalline silicon. The cleaning basket 1 in accordance with the present embodiment is used for at least the cleaning of the polycrystalline silicon in the first cleaning bath.

The drying step can be also performed with use of the cleaning basket 1. Specifically, after the cleaning basket 1 has been immersed in the second cleaning bath, the cleaning basket 1 is taken out of the second cleaning bath and is then accommodated in a drying machine in the drying step described above. The polycrystalline silicon accommodated in the cleaning basket 1 is dried by hot air from the drying machine.

### <Configuration of cleaning basket>

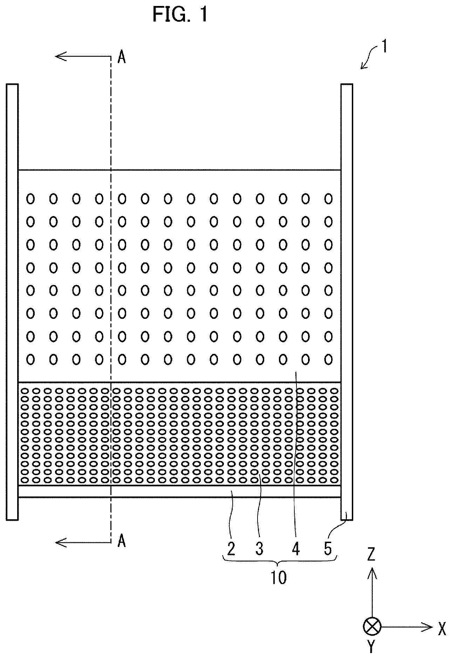

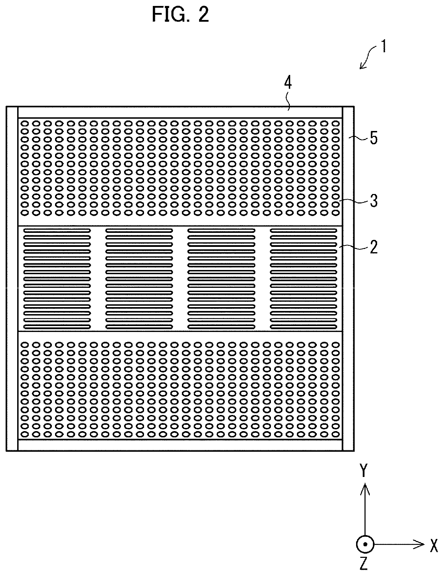

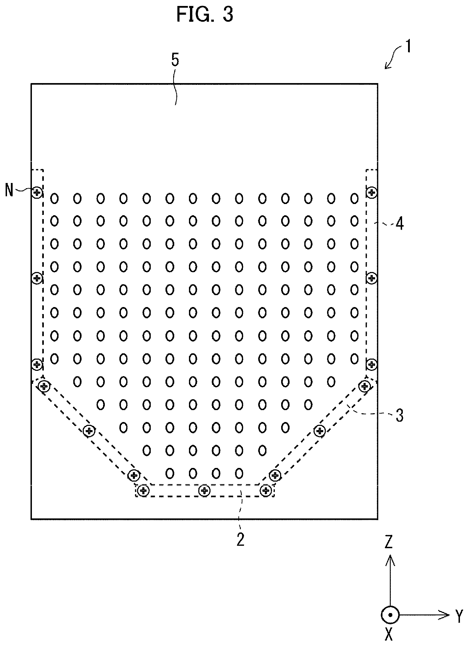

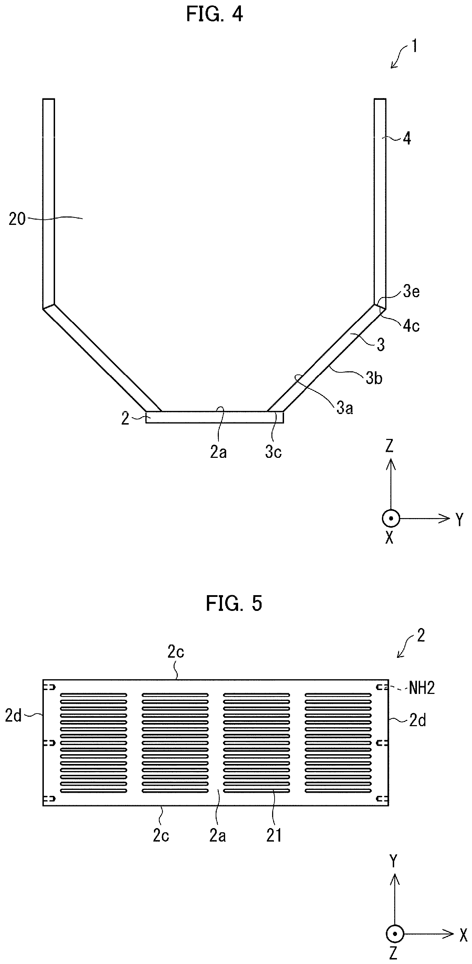

Fig. 1 is a side view illustrating a cleaning basket 1 in accordance with an embodiment of the present invention. Fig. 2 is a plan view illustrating the cleaning basket 1 illustrated in Fig. 1. Fig. 3 is a front view illustrating the cleaning basket 1 illustrated in Fig. 1. In Fig. 1, a longer-side direction of the cleaning basket 1 is an X-axis direction, a height direction of the cleaning basket 1 is a Z-axis direction, and a width direction of the cleaning basket 1 (a shorter-side direction of the cleaning basket) is a Y-axis direction. In addition, a direction from an opening side of the cleaning basket 1 toward a bottom plate 2 is a downward direction, and a direction from the bottom plate 2 toward the opening side of the cleaning basket 1 is an upward direction. Fig. 4 is a cross-sectional view of the cleaning basket 1 illustrated in Fig. 1, taken along A-A line.

As illustrated in Figs. 1 to 4, the cleaning basket 1 includes a plurality of component parts 10 each made of a resin and screws N each made of a resin. The plurality of component parts 10 are coupled to each other by screwing the screws N.

The component parts 10 and the screws N are each made of a fluorine resin. The fluorine resin has high chemical resistance and thus makes it possible to reduce a risk of cracking and peeling due to an acidic chemical solution for cleaning used in the cleaning step. Further, the fluorine resin also has high heat resistance. This makes it possible to, after etching in the cleaning step, dry polycrystalline silicon in a state in which the polycrystalline silicon is accommodated in the cleaning basket 1. Furthermore, the fluorine resin has a high mechanical strength, among resins, and thus makes it possible to reduce an amount by which the cleaning basket 1 is scraped when the polycrystalline silicon is brought into contact with the cleaning basket 1. This makes it possible to prevent the polycrystalline silicon from being contaminated by the resin fragments from the cleaning basket 1 scraped.

### <Component Parts>

As illustrated in Figs. 1 to 4, the cleaning basket 1 includes, as the component parts 10, a bottom plate 2, first side plates 3, second side plates 4, and third side plates 5. The bottom plate 2, the first side plates 3, the second side plates 4, and the third side plates 5 have the same thickness. Making the thicknesses of these plates the same makes it possible to reduce a material cost.

### <Bottom Plate>

As illustrated in Fig. 1, the bottom plate 2 is disposed substantially parallel to an installation plane on which the cleaning basket 1 is installed and supports polycrystalline silicon when the polycrystalline silicon is accommodated in the cleaning basket 1. Fig. 5 is a plan view illustrating the bottom plate 2 of the cleaning basket 1 illustrated in Fig. 1. As illustrated in Fig. 5, the bottom plate 2 is a board member having a substantially rectangular shape and is provided with a plurality of long holes 21 extending in a longer-side direction of the bottom plate 2 (in the X-axis direction). The plurality of long holes 21 are aligned along a shorter-side direction of the bottom plate 2 (along the Y-axis direction). A plurality of groups of the plurality of long holes 21, which are aligned along the Y-axis direction, are aligned in the X-axis direction. The holes that are formed in the bottom plate 2 so as to be long holes increase an aperture ratio which is a ratio of a total of aperture areas of the plurality of long holes 21, relative to an area of an inner surface 2a of the bottom plate 2. Thus, the cleaning basket 1 exhibits better water drainage and better air expulsion.

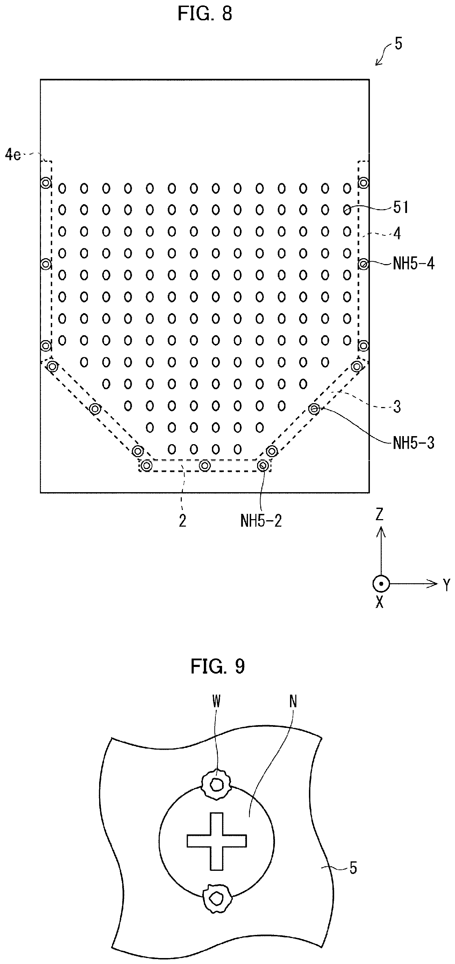

The bottom plate 2 has side surfaces 2d in the shorter-side direction thereof which are each provided with a plurality of screw holes NH2 along the Y-axis direction of the bottom plate 2. The screw holes NH2 are formed in each of the side surfaces 2d so as to be depressed with respect to the side surface 2d. As illustrated in Fig. 8, the third side plates 5 are provided with screw holes NH5-2 formed at respective positions corresponding to positions of the screw holes NH2 formed in the bottom plate 2. The third side plates 5 and the bottom plate 2 can be coupled to each other by aligning the positions of the screw holes NH2 and the respective positions of the screw holes NH5-2 with each other and causing the screws N to pass through the screw holes NH5-2 and to be screwed into the screw holes NH5-2 and the screw holes NH2.

### <First Side Plates>

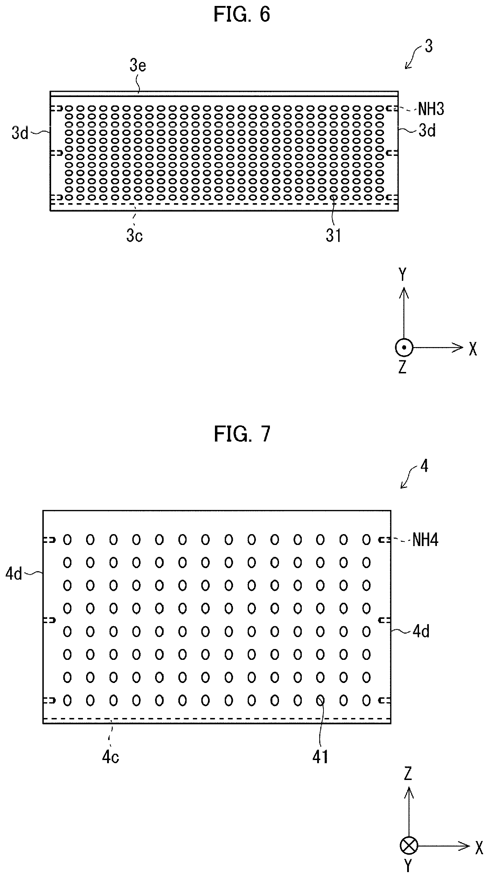

The first side plates 3 are connected to the bottom plate 2 along the longer-side direction of the bottom plate 2, as illustrated in Fig. 1, and extend in a direction away from the inner surface 2a (surface) of the bottom plate 2, as illustrated in Fig. 4. Fig. 6 is a plan view illustrating such a first side plate 3 of the cleaning basket 1 illustrated in Fig. 1. As illustrated in Fig. 6, the first side plate 3 is a board member having a substantially rectangular shape and is provided with a plurality of holes 31.

The first side plate 3 has side surfaces 3d in a shorter-side direction thereof which are each provided with a plurality of screw holes NH3 along the shorter-side direction of the first side plate 3. The screw holes NH3 are provided in each of the side surfaces 3d so as to be depressed with respect to the side surface 3d. As illustrated in Fig. 8, the third side plates 5 are provided with screw holes NH5-3 formed at positions corresponding to positions of the screw holes NH3 provided in the first side plates 3. The third side plates 5 and the first side plates 3 can be coupled to each other by aligning the positions of the screw holes NH3 and the respective positions of the screw holes NH5-3 with each other and causing the screws N to pass through the screw holes NH5-3 and to be screwed into the screw holes NH5-3 and the screw holes NH3.

Further, as illustrated in Fig. 4, the first side plates 3 are each connected to the inner surface 2a of the bottom plate 2 along a longer-side direction of the inner surface 2a and each incline in an upward and outward direction. The first side plates 3 have respective bottom surfaces 3c each of which abuts on the inner surface 2a of the bottom plate 2 along an outer edge 2c of the bottom plate 2 in the longer-side direction of the bottom plate 2. Each of the first side plates 3 abuts on the inner surface 2a and inclines with respect to the bottom plate 2. Therefore, the bottom surface 3c of each of the first side plates 3 is not perpendicular to an inner surface 3a of the first side plate 3 and an outer surface 3b of the first side plate 3.

The first side plates 3 are provided obliquely with respect to the bottom plate 2, so that it is easy for polycrystalline silicon to gather on the bottom plate 2 when the polycrystalline silicon is accommodated in the cleaning basket 1. Further, the cleaning basket 1 exhibits better water drainage. Furthermore, a load of the polycrystalline silicon accommodated in the cleaning basket 1 is applied dispersedly to the bottom plate 2 and the first side plates 3. This makes it possible to reduce the load applied by the polycrystalline silicon to the bottom plate 2. Thus, it is possible to reduce deformation of the bottom plate 2 due to the load.

### <Second Side Plates>

The second side plates 4 are connected to the bottom plate 2 along the longer-side direction of the bottom plate 2 via the first side plates 3, as illustrated in Fig. 1, and extend in a direction away from the inner surface 2a of the bottom plate 2, as illustrated in Fig. 4. Specifically, the second side plates 4 have respective bottom surfaces 4c which abut on top surfaces 3e of the first side plates 3 so as to cause the second side plates 4 to extend in a direction substantially perpendicular to the inner surface 2a of the bottom plate 2. Fig. 7 is a plan view illustrating such a second side plate 4 of the cleaning basket 1 illustrated in Fig. 1. As illustrated in Fig. 7, the second side plate 4 is a board member having a substantially rectangular shape and is provided with a plurality of holes 41.

In addition, the second side plate 4 has side surfaces 4d in a shorter-side direction thereof which are each provided with a plurality of screw holes NH4 along the Z-axis direction. The screw holes NH4 are provided in each of the side surfaces 4d so as to be depressed with respect to the side surface 4d. As illustrated in Fig. 8, the third side plates 5 are provided with screw holes NH5-4 formed at positions corresponding to positions of the screw holes NH4 provided in the second side plates 4. The third side plates 5 and the second side plates 4 can be coupled to each other by aligning the positions of the screw holes NH4 and the respective positions of the screw holes NH5-4 with each other and causing the screws N to pass through the screw holes NH5-4 and to be screwed into the screw holes NH5-4 and the screw holes NH4.

### <Third Side Plates>

As illustrated in Fig. 1, the third side plates 5 are connected to the bottom plate 2 along the shorter-side direction of the bottom plate 2 and extend in a direction away from the inner surface 2a of the bottom plate 2. Therefore, the first side plates 3, the second side plates 4, and the third side plates 5 are connected to a periphery of the bottom plate 2.

As illustrated in Figs. 1 and 3, the third side plates 5 that makes a pair are connected to respective ends of the bottom plate 2, respective ends of each of the first side plates 3, and respective ends of each of the second side plates 4, so that the pair of the third side plates 5 sandwich therebetween the bottom plate 2, the first side plates 3, and the second side plates 4. In addition, as illustrated in Fig. 3, the bottom plate 2, the first side plates 3, and the second side plates 4 are each fixed to the third side plates 5 by screwing the screws N, so that the bottom plate 2, the first side plates 3, and the second side plates 4 are coupled to each other. This forms an accommodation space 20 for accommodating polycrystalline silicon, as illustrated in Fig. 4.

Fig. 8 is a plan view illustrating such a third side plate 5 of the cleaning basket 1 illustrated in Fig. 3. The third side plate 5 is a board member having a substantially rectangular shape and is provided with a plurality of holes 51. The plurality of holes 51 are formed at positions higher than a connection part between the bottom plate 2 and the third side plate 5 and connection parts between the third side plate 5 and the first side plates 3.

### <Screws>

The screws N are flat head screws each made of a resin. If pan head screws, truss head screws, or the like were used for coupling of the bottom plate 2, the first side plates 3, the second side plates 4, and the third side plates 5 together, the screw heads thereof would protrude from surfaces of the third side plates 5. Accordingly, there would be a possibility that when polycrystalline silicon is cleaned in a state in which the screw heads protrude from the surfaces of the third side plates 5, the screw heads protruding would be scraped, resulting in occurrence of resin fragments, and the resin fragments would contaminate the polycrystalline silicon.

In light of the above, the present embodiment employs the flat head screws as the screws N. This causes top surfaces of the screw heads to be flush with the surfaces of the third side plates 5. Therefore, it is possible to prevent contamination of the polycrystalline silicon due to protrusion of the screw heads of the screws N from the surfaces of the third side plates 5.

Note that a configuration also may be employed in which although the screws N are not the flat head screws, the top surfaces of the screw heads are caused to be flush with the surfaces of the third side plates 5 by grinding the screw heads so as to prevent the screw heads from protruding from the surfaces of the third side plates 5. Further, a member used for coupling of the component parts 10 is not limited to the screws N. The member used for the coupling of the component parts 10 can be any member, provided that the member is made of a material having high chemical resistance and high heat resistance and can couple the component parts 10 to each other without protruding from surfaces of the component parts 10. Examples of such a member used for the coupling of the component parts 10 include a member such as a rivet made of a resin.

### <Assembling method>

The following will describe a method for assembling the cleaning basket 1. First, the bottom plate 2 is fixed to the third side plates 5 by screwing the screws N. After the bottom plate 2 has been fixed to the third side plates 5, the first side plates 3 are fixed to the third side plates 5 by screwing the screws N such that the first side plates 3 each abut on the inner surface 2a of the bottom plate 2 along the longer-side direction of the bottom plate 2. After the first side plates 3 have been fixed to the third side plates 5, the second side plates 4 are fixed to the third side plates 5 by screwing the screws N such that the respective bottom surfaces 4c of the second side plates 4 abut on the top surfaces 3e of the first side plates 3 on a side opposite to a bottom plate 2 side.

Fixing the bottom plate 2, the first side plates 3, and the second side plates 4 to the third side plates 5 causes the positions of the bottom plate 2, the first side plates 3, and the second side plates 4 to be fixed relative to each other. Thus, for example, there is no need for fixing the bottom plate 2 and the first side plates 3 to each other in order to form the accommodation space 20. This eliminates the need for welding the bottom plate 2 and the first side plates 3 together. Similarly, there is no need for fixing the first side plates 3 and the second side plates 4 to each other in order to form the accommodation space 20. This eliminates the need for welding the first side plates 3 and the second side plates 4 together.

As described above, the cleaning basket 1 can be assembled without welding. Therefore, it is possible to configure the cleaning basket 1 without forming a part susceptible to a cleaning liquid where cracking and peeling are likely to occur in the cleaning step. This makes it possible to prevent contamination of the polycrystalline silicon in the cleaning step.

Further, the positions of the bottom plate 2, the first side plates 3, and the second side plates 4 are determined in accordance with the positions of the plurality of screw holes NH5-2 to NH5-4 formed in each of the third side plates 5. Therefore, it is possible to reduce variation in final products produced by an assembler, by forming the screw holes NH5-2 to NH5-4 in each of the third side plates 5 in advance. In addition, it is possible to easily dispose the first side plates 3 to be disposed obliquely at predetermined angles with respect to the bottom plate 2 and the second side plates 4.

Fig. 9 is a view for describing a welding portion W. With reference to Fig. 9, the following will describe locking of the screws N at the time when the screws N are screwed. After screwing of the screws N for fixing the bottom plate 2, the first side plates 3, and the second side plates 4 illustrated in Fig. 3, to the third side plates 5, a portion of a boundary between each of the screws N and the third side plate 5 is melted, so that a welding portion W is formed at the boundary between the screw N and the third side plate 5, as illustrated in Fig. 9. This makes it possible to prevent the screw N from loosening and to prevent the screw N from coming off from a place where the screw N is screwed. In addition, after the welding portion W has been formed, a torque is applied to the screw N at a torque value of not less than 45cN m in a reverse rotation direction with use of a torque driver, so that it is confirmed that the screw N does not come off from the place where the screw N is fitted.

In this way, without welding the bottom plate 2, the first side plates 3, the second side plates 4, and the third side plates 5 together, it is possible to reduce variation in strength of the cleaning basket 1 caused by an assembler, by, for example, forming the welding portion W and confirming that the screw N does not come off from the place where the screw N is screwed.

### <Effects>

As described above, the polycrystalline silicon used as, for example, a raw material for silicon semiconductors or a raw material for solar cells needs to be highly pure. Specifically, in a case where a slight amount of heavy metal is adhered to a surface of polycrystalline silicon, such polycrystalline silicon is regarded as a defective product. In order to keep the polycrystalline silicon highly pure, a method for producing the highly pure polycrystalline silicon needs to be achieved with multiple elaborate measures against contamination.

In the present embodiment, the component parts 10 of the cleaning basket 1 which are each made of a resin are coupled to each other by screwing the screws N each made of a resin. This eliminates the need for welding the component parts 10 together at the time of assembly of the cleaning basket 1. This prevents contamination of the polycrystalline silicon in the cleaning step and achieves the cleaning basket 1 that maintains high purity as described above.

According to the configuration, it is possible to reduce waste of the polycrystalline silicon due to contamination of the polycrystalline silicon, in the production process of the polycrystalline silicon. This can contribute to achievement of Goal 12 "RESPONSIBLE CONSUMPTION AND PRODUCTION" of Sustainable Development Goals (SDGs).

### [Example 1]

### <Cleaning/Washing and Drying of Polycrystalline Silicon>

The following will describe cleaning/washing and drying of polycrystalline silicon in Example 1. First, a polycrystalline silicon rod produced through the Siemens process was crushed to pieces with use of a hammer. Polycrystalline silicon pieces thus obtained were accommodated in a cleaning basket. The cleaning basket accommodating the polycrystalline silicon pieces was then immersed in a first cleaning bath filled with fluonitric acid, so that the polycrystalline silicon pieces were cleaned.

Next, the cleaning basket was taken out of the first cleaning bath and was then immersed in a second cleaning bath filled with ultrapure water, so that the fluonitric acid adhered to the polycrystalline silicon pieces was washed away. After that, the cleaning basket was taken out of the second cleaning bath and was then accommodated in a drying machine. Hot air was blown from the drying machine to the polycrystalline silicon pieces accommodated in the cleaning basket, so that the polycrystalline silicon pieces were dried.

After the above-described cleaning/washing and drying of the polycrystalline silicon had been repeatedly performed with use of the cleaning basket of Example 1 one or more times a day in average for three months, an appearance of the cleaning basket and the presence or absence of a resin fragment in a cleaning liquid were visually observed. Note that, in Comparative Example 1 described later, cleaning/washing and drying of polycrystalline silicon pieces were performed by the above-described method, and an appearance of the cleaning basket and the presence or absence of a resin fragment in a cleaning liquid were visually observed.

### <Configuration of cleaning basket>

In Example 1, a cleaning basket was used in which component parts and screws are each made of polyvinylidene fluoride (PVDF) resin. More specifically, the cleaning basket used in Example 1 had, as the component parts, a bottom plate and side plates, and the component parts were coupled to each other by screwing the screws. In the cleaning basket used in Example 1, no welding part was formed for coupling of the component parts.

### <Results>

Table 1 below shows results of Example 1 and Comparative Example 1. As shown in Table 1, in the cleaning basket used in Example 1, neither cracking nor peeling due to degradation was found. In addition, no resin fragment was found in the cleaning liquid.

**[Table 1]**

| | Component part | Screw | Welding part | Cracking and peeling due to degradation | Resin fragment in cleaning liquid |
|---|---|---|---|---|---|
| Example 1 | PVDF | PVDF | Absent | Absent | Absent |
| Comparative Example 1 | PVDF | - | Present | Present (Degradation found in welding part) | Present (Resin powder left on filter) |

### [Comparative Example 1]

In Comparative Example 1, polycrystalline silicon was cleaned/washed and dried as in Example 1 except that no screw was used in a cleaning basket and that welding parts were formed for coupling of the component parts of the cleaning basket.

As shown in Table 1, in the cleaning basket used in Comparative Example 1, slight whitening at the welding parts due to degradation was found. In addition, resin fragments generated from the cleaning basket were found in the cleaning liquid, and a resin powder was left on a cleaning liquid filter installed at an outlet of the first cleaning bath.

Aspects of the present invention can also be expressed as follows:
A cleaning basket in accordance with an aspect of the present invention is a cleaning basket used for cleaning polycrystalline silicon in a state in which the polycrystalline silicon is accommodated in the cleaning basket, the cleaning basket including a plurality of component parts each made of a resin, the plurality of component parts being coupled to each other by screwing screws each made of a resin.

According to the above configuration, since the component parts of the cleaning basket which are each made of a resin are coupled to each other by screwing the screws each made of a resin, there is no need for welding for coupling of the component parts at the time of assembly of the cleaning basket. Therefore, it is possible to configure the cleaning basket without forming a part susceptible to a cleaning liquid in which organic components and carbon are easily eluted due to degradation caused by a chemical solution and in which cracking and peeling are likely to occur. As a result, it is possible to achieve the cleaning basket enabling prevention of contamination of the polycrystalline silicon in the cleaning step.

Further, the cleaning basket may be configured such that the component parts and the screws are each made of a fluorine resin. According to the above configuration, the component parts and the screws are each made of a fluorine resin, which has high chemical resistance, and thus are particularly difficult to be degraded by a chemical solution. Thus, it is possible to reduce risks of elution of organic components and carbon and of cracking and peeling. In addition, the component parts and the screws are made of the same material and thus have the same thermal expansion rate. Thus, it is possible to prevent a defect caused by difference in thermal expansion rate between the component parts and the screws.

Further, the cleaning basket may be configured such that the component parts includes a bottom plate and side plates that are connected to a periphery of the bottom plate and that extend in a direction away from a surface of the bottom plate, and the bottom plate and each of the side plates are coupled to each other by screwing the screws, so that an accommodation space for accommodating the polycrystalline silicon is formed.

According to the above configuration, the bottom plate made of a resin and the side plates each made of the resin are coupled to each other by screwing the screws each made of a resin, so that the accommodation space for accommodating the polycrystalline silicon is formed. This makes it possible to configure the cleaning basket without forming, in a portion in which the polycrystalline silicon is accommodated, a part susceptible to a cleaning liquid where degradation due to a chemical solution easily occurs and cracking and peeling are likely to occur in the cleaning step of cleaning the polycrystalline silicon with use of a cleaning solution. As a result, it is possible to achieve the cleaning basket enabling prevention of contamination of polycrystalline silicon in the cleaning step.

The present invention is not limited to the description of the embodiments above, but may be altered in various ways by a skilled person within the scope of the claims. The present invention encompasses, in its technical scope, any configuration based on an appropriate combination of technical means disclosed in different embodiments.

### Reference Signs List

- 1: Cleaning basket
- 2: Bottom plate
- 2a: Inner surface (surface)
- 3: First side plate (side plate)
- 4: Second side plate (side plate)
- 5: Third side plate (side plate)
- 10: Component part
- 20: Accommodation space
- N: Screw

## Claims

1. A cleaning basket used for cleaning polycrystalline silicon in a state in which the polycrystalline silicon is accommodated in the cleaning basket, the cleaning basket comprising
- a plurality of component parts each made of a resin,
- the plurality of component parts being coupled to each other by screwing screws each made of a resin.

2. The cleaning basket according to claim 1, wherein the component parts and the screws are each made of a fluorine resin.

3. The cleaning basket according to claim 1 or 2, wherein:
- the component parts includes a bottom plate and side plates that are connected to a periphery of the bottom plate and that extend in a direction away from a surface of the bottom plate; and
- the bottom plate and each of the side plates are coupled to each other by screwing the screws, so that an accommodation space for accommodating the polycrystalline silicon is formed.
